# EUROPEAN PATENT APPLICATION

(11) **EP 4 395 509 A1**
(43) Date of publication of application: **03.07.2024**
(21) Application number: 23220345.5
(22) Date of filing: 27.12.2023
(51) Int. Cl.: H10K 59/122, H10K 59/124, H10K 59/131, H10K 59/80, H10K 59/88

(54) **ORGANIC LIGHT-EMITTING DIODE DISPLAY DEVICE**

(30) Priority: 26.12.2022 KR 20220184764
(71) Applicant: LG Display Co., Ltd., Seoul 07336 (KR)
(72) Inventor: HU, Jae-Sung, 10845 Paju-si (KR); HAN, Joon-Soo, 10845 Paju-si (KR); AN, Jun-Ha, 10845 Paju-si (KR); CHOI, Jae-Hyuk, 10845 Paju-si (KR)
(74) Representative: Ter Meer Steinmeister & Partner

(57) **Abstract**

An organic light-emitting diode display device can include a substrate including sub-pixels each having an emission area and a non-emission area; a horizontal line and vertical lines crossing each other to define the sub-pixels; a circuit portion including a thin film transistor in the non-emission; an overcoat layer over the thin film transistors and including micro lenses in the emission area; a bank over the overcoat layer and having an opening; and a light-emitting diode in the emission over the overcoat layer and connected to the thin film transistor, wherein the vertical lines includes first, second, third, and fourth lines, and wherein for a first sub-pixel, an edge of the opening of the bank is spaced apart from the first and second lines, and for a second sub-pixel, an edge of the opening of the bank coincides with one side of each of the third and fourth lines.

## Description

### CROSS-REFERENCE TO RELATED APPLICATION

The present application claims priority to Korean Patent Application No. 10-2022-0184764 filed in the Republic of Korea on December 26, 2022.

### BACKGROUND

### Field of the Disclosure

The present disclosure relates to a display device, and more particularly, to an organic light-emitting diode display device.

### Discussion of the Background Art

As the information society progresses, a demand for different types of display devices increases, and flat panel display devices (FPD) such as liquid crystal display devices (LCD) and organic light-emitting diode display devices (OLED) have been developed and applied to various fields.

Among the flat panel display devices, organic light-emitting diode display devices, which are also referred to as organic electroluminescent display devices, emit light due to the radiative recombination of an exciton. The exciton is formed from an electron and a hole by injecting charges into a light-emitting layer between a cathode for injecting electrons and an anode for injecting holes in a light-emitting diode.

The organic light-emitting diode display device can be formed over a flexible substrate, such as plastic, and offers various advantages and improved properties. For instance, because it is self-luminous, the organic light-emitting diode display device has an excellent contrast ratio and an ultra-thin thickness, and has a response time of several micro seconds. As such, there are advantages in displaying moving images and videos without delays using the organic light-emitting diode display device.

Additionally, the organic light-emitting diode display device has a wide viewing angle and is stable under low temperatures. Further, since the organic light-emitting diode display device is generally driven by a low voltage of direct current (DC) (e.g., 5V to 15V), it is easy to design and manufacture the driving circuits of the organic light-emitting display device.

On the other hand, in the process of light generated in the light-emitting layer of the organic light-emitting diode display device passing through various components and being emitted to the outside, if some light is not emitted to the outside due to total internal reflection at the interface between the components, the light extraction efficiency is reduced, which leads to decrease the luminance and increase the power consumption.

### SUMMARY OF THE DISCLOSURE

Accordingly, an object of the present disclosure is to provide an organic light-emitting diode display device that substantially obviates one or more of the limitations and disadvantages described above and associated with the background art.

More specifically, an object of the present disclosure is to provide an organic light-emitting diode display device with improved light extraction efficiency.

One or more of these objects are solved by the features of the independent claim. Additional features and aspects will be set forth in the description that follows, and in part will be apparent from the description, or can be learned by practice of the present disclosure provided herein. Other features and aspects of the inventive concepts can be realized and attained by the structure particularly pointed out in the written description, or derivable therefrom, and the claims hereof as well as the appended drawings.

According to the present disclosure, light extraction efficiency of an organic light-emitting diode display device is improved by employing micro lenses. According to one aspect, an organic light-emitting diode display device includes: a substrate including a plurality of sub-pixels associated with one pixel, each sub-pixel having an emission area and a non-emission area; a horizontal line extending in a first direction and a plurality of vertical lines extending (in parallel) in a second direction on the substrate, wherein the horizontal line crosses over the plurality of vertical lines (e.g. to define at least partially the plurality of sub-pixels); a circuit portion in the non-emission area of each sub-pixel, and including a thin film transistor in each sub-pixel; an overcoat layer on the thin film transistors, and including a plurality of micro lenses in the emission area of each sub-pixel; a bank on the overcoat layer, and having an opening corresponding to the emission area of each sub-pixel; and a light-emitting diode in the emission area of each sub-pixel on the overcoat layer, and connected to the corresponding thin film transistor. The plurality of vertical lines may include a first, a second, a third, and a fourth line. For a first sub-pixel among the plurality of sub-pixels, an edge of the opening of the bank may be spaced apart from the first and second line, and/or for a second sub-pixel among the plurality of sub-pixels, an edge of the opening of the bank may coincide or be aligned with one side of each of the third and fourth lines. Alternatively or additionally, for a first sub-pixel among the plurality of sub-pixels, a width of the opening of the bank (e.g. in the first direction) may be smaller than a distance (e.g. in the first direction) between the first and second line, and/or for a second sub-pixel among the plurality of sub-pixels, a width of the opening of the bank (e.g. in the first direction) may be equal to a distance (e.g. in the first direction) between the third and fourth line.

According to a further aspect, an organic light-emitting diode display device includes: a substrate including a plurality of sub-pixels associated with one pixel, each sub-pixel having an emission area and a non-emission area; a horizontal line of a first direction and a plurality of vertical lines of a second direction over the substrate, wherein the horizontal line crosses over the plurality of vertical lines to define the plurality of sub-pixels; a circuit portion in the non-emission area of each sub-pixel, and including a thin film transistor in each sub-pixel; an overcoat layer over the thin film transistors, and including a plurality of micro lenses in the emission area of each sub-pixel; a bank over the overcoat layer, and having an opening corresponding to the emission area of each sub-pixel; and a light-emitting diode in the emission area of each sub-pixel over the overcoat layer, and connected to the corresponding thin film transistor, wherein the plurality of vertical lines includes first, second, third, and fourth lines, and wherein for a first sub-pixel among the plurality of sub-pixels, an edge of the opening of the bank is spaced apart from the first and second lines, and for a second sub-pixel among the plurality of sub-pixels, an edge of the opening of the bank coincides with one side of each of the third and fourth lines.

An organic light-emitting diode display device according to another aspect of the present disclosure includes: a substrate including a plurality of sub-pixels associated with one pixel, each sub-pixel having an emission area and a non-emission area; a horizontal line of a first direction and a plurality of vertical lines of a second direction over the substrate, wherein the horizontal line crosses over the plurality of vertical lines to define the plurality of sub-pixels; a circuit portion in the non-emission area of each sub-pixel, and including a thin film transistor in each sub-pixel; an overcoat layer over the thin film transistors, and including a plurality of micro lenses in the emission area of each sub-pixel; a bank over the overcoat layer, and having an opening corresponding to the emission area of each sub-pixel; and a light-emitting diode in the emission area of each sub-pixel over the overcoat layer, and connected to the corresponding thin film transistor, wherein the plurality of vertical lines includes first, second, third, and fourth lines, and wherein for a first sub-pixel among the plurality of sub-pixels, a width of the opening of the bank is smaller than a distance between the first and second lines, and for a second sub-pixel among the plurality of sub-pixels, a width of the opening of the bank is equal to a distance between the third and fourth lines.

The organic light-emitting diode display device according to any one of these aspects may include one or more of the following features:

The term "width" of an element may refer to a dimension of said element in the first direction.

There may be (exactly or at least) four sub-pixels associated with one pixel, e.g. a red, a green, a blue and a white sub-pixel. The red, green and blue sub-pixels may include a color filter. The white sub-pixel may dispense with a color filter. Thus, the plurality of sub-pixels may include the first sub-sub-pixel, the second sub-pixel, a third sub-pixel and a fourth sub-pixel, which are provided on the substrate in the first direction.

The horizontal line may be a scan line or gate line. The horizontal line may be provided in plurality. The vertical lines may include at least one of data lines, reference lines and power lines. The first direction and the second direction may be perpendicular to each other.

The first sub-pixel may be defined between or by the first line and the second line among the vertical lines. The second sub-pixel may be defined between or by the third line and the fourth line among the vertical lines. The vertical lines, in particular the first and second lines and/or the third and fourth lines, may be disposed outside of the emission areas of the sub-pixels.

An edge of the opening of the bank defining the emission area of the first sub-pixel may be spaced apart from the first line (e.g. a power line) and the second line (e.g. a data line). A width (e.g. in the first direction) of the opening of the bank defining the emission area of the first sub-pixel may be smaller than a distance between the first line (e.g. a power line) and the second line (e.g. a data line). The first line and the second line may be disposed (fully) outside of the emission area of the first sub-pixel. The first sub-pixel may be a red or white sub-pixel.

An edge of the opening of the bank defining the emission area of the second sub-pixel may coincide or be aligned with one side (or edge) of the third line (e.g. a data line) and of the fourth line (e.g. a reference line), respectively. A width (e.g. in the first direction) of the opening of the bank defining the emission area of the second sub-pixel may be equal to a distance (e.g. in the first direction) between the third line (e.g. a data line) and the fourth line (e.g. a reference line). The third line and the fourth line may be disposed outside of the emission area of the second sub-pixel. The second sub-pixel may be a blue or green sub-pixel.

One of the first line and the fourth line may be a power line, e.g. a high potential line for supplying high potential voltage. One of the first line and the fourth line may be a reference line, e.g. for supplying a reference voltage. One of the first line and the fourth line may be a power line, and the other of the first line and the fourth line may be a reference line.

The second line and/or the third line may be a data line.

A width of the third line (e.g. in the first direction) may be wider than a width of the second line. In particular, a width of a portion of the third line may be wider than a width of a portion of the second line, wherein the portions of the third line and of the second line are respectively disposed between the emission areas of two adjacent sub-pixels, respectively.

A color filter may be provided between the substrate and the light-emitting diode in at least one of the first and second sub-pixels.

The overcoat layer includes a plurality of micro lenses in the emission area of each sub-pixel. That is, a plurality of micro lenses may be formed in the overcoat layer.

The micro lenses may be at least partially included in the emission area.

At least one of the first and second sub-pixels may include at least one dummy lens formed in the overcoat layer. In particular, for each of the first and second sub-pixels, the overcoat layer may further include a dummy lens in the non-emission area. The dummy lens may be spaced apart from the opening. The dummy lens may be disposed fully within the non-emission area, i.e. fully outside the emission area.

The light-emitting diode may include a first electrode on the overcoat layer, a light-emitting layer on the first electrode in the emission area, and a second electrode on the light-emitting layer. The first electrode may have two opposite edges, e.g. in the first direction. The two opposite edges may be respectively overlapped with the bank. That is, the bank may be formed on the two opposite edges of the first electrode.

The dummy lens may overlap each of opposite edges of the first electrode facing each other along the first direction, and/or may be spaced apart from opposite edges of the first electrode facing each other along the second direction. The first electrode may have a shape corresponding to the micro lenses formed in the overcoat layer in the emission area and corresponding to the at least one dummy lens formed in the overcoat layer in the non-emission area.

The dummy lens may be overlapped by an edge of the first electrode, the edge extending in the second direction. The dummy lens may be spaced apart from opposite edges of the first electrode extending in the first direction. A plurality of dummy lenses may be formed in the first and/or second sub-pixel and the dummy lenses may be overlapped by opposite edges of the first electrode, the edges extending in parallel in the second direction.

The light-emitting diode may have a shape corresponding to the overcoat layer in the emission area. That is, the light-emitting diode may have a shape corresponding to the micro lenses formed in the overcoat layer in the emission area.

The dummy lens may have a same size and/or a same shape as the micro lenses.

Each of the micro lenses may have an edge extending parallel to the first or second direction. Each of the micro lenses may have an edge extending parallel to the first direction and/or an edge extending parallel to the second direction.

The plurality of sub-pixels may include the first sub-sub-pixel, the second sub-pixel, a third sub-pixel and a fourth sub-pixel, which are provided over on the substrate along the first direction, e.g. in the first direction in this order.

The micro lenses in at least one of the sub-pixels, i.e. in at least one of the first, second, third, and fourth sub-pixels, may be rotated at a rotation angle, so that a line connecting centers of the micro lenses adjacent to each other has a specific angle (e.g. greater than 0° and/or smaller than 90°) with respect to the first direction. The micro lenses in at least one of the sub-pixels, i.e. in at least one of the first, second, third, and fourth sub-pixels, may be rotated at a rotation angle, so that a line connecting centers of the micro lenses adjacent to each other has a specific angle (e.g. greater than 0° and/or smaller than 90°) with respect to the first direction and/or to the second direction. All edges of each micro lens may be inclined with respect to the first and second directions. The micro lenses may have no edges extending in parallel to the first direction and/or to the second direction.

The rotation angle of the micro lenses may be greater than 0 degrees and/or may be equal to or less than 60 degrees. The rotation angle may be defined as the angle between the line connecting centers of adjacent micro lenses and the first direction.

Each of the micro lenses may have a pentagonal shape. The plurality of micro lenses may have a honeycombed shape.

It is to be understood that both the foregoing general description and the following detailed description are examples and are intended to provide further explanation of the inventive concepts as claimed.

### BRIEF DESCRIPTION OF THE DRAWINGS

The accompanying drawings, which are included to provide a further understanding of the present disclosure and which are incorporated in and constitute a part of this application, illustrate aspects of the disclosure and together with the description serve to explain various principles of the present disclosure.

In the drawings:
FIG. 1 is an example of an equivalent circuit diagram of one sub-pixel of an organic light-emitting diode display device according to an embodiment of the present disclosure;
FIG. 2 is a schematic cross-sectional view of the organic light-emitting diode display device according to the embodiment of the present disclosure;
FIG. 3 is a schematic plan view of an organic light-emitting diode display device according to a first embodiment of the present disclosure;
FIG. 4 is a cross-sectional view corresponding to the line I-I' of FIG. 3;
FIG. 5 is a cross-sectional view corresponding to the line II-II' of FIG. 3;
FIG. 6 is a schematic plan view of an organic light-emitting diode display device according to a second embodiment of the present disclosure;
FIG. 7 is a schematic plan view of an organic light-emitting diode display device according to a third embodiment of the present disclosure;
FIG. 8 is a cross-sectional view corresponding to the line III-III' of FIG. 7; and
FIG. 9 is a schematic cross-sectional view of an organic light-emitting diode display device according to a fourth embodiment of the present disclosure.

### DETAILED DESCRIPTION OF THE EMBODIMENTS

Advantages and features of the present disclosure and methods for achieving them will be made clear from embodiments described in detail below with reference to the accompanying drawings. The present disclosure can, however, be implemented in many different forms and should not be construed as being limited to the embodiments set forth herein, and the embodiments are provided such that this disclosure will be thorough and complete and will fully convey the scope of the present disclosure to those skilled in the art to which the present disclosure pertains.

Shapes, sizes, ratios, angles, numbers, and the like disclosed in the drawings for describing the embodiments of the present disclosure are illustrative, and thus the present disclosure is not limited to the illustrated matters. The same reference numerals refer to the same components throughout this disclosure. Further, in the following description of the present disclosure, when a detailed description of a known related art is determined to unnecessarily obscure the gist of the present disclosure, the detailed description thereof will be omitted herein or may be briefly discussed.

When terms such as "including," "having," "comprising" and the like mentioned in this disclosure are used, other parts can be added unless the term "only" is used herein. Further, when a component is expressed as being singular, being plural is included unless otherwise specified.

In analyzing a component, an error range is interpreted as being included even when there is no explicit description.

In describing a positional relationship, for example, when a positional relationship of two parts/layers is described as being "over," "on," "above," "below," "under," "next to," or the like, one or more other parts/layers can be provided between the two parts/layers, unless the term "immediately" or "directly" is used therewith.

In describing a temporal relationship, for example, when a temporal predecessor relationship is described as being "after," "subsequent," "next to," "prior to," or the like, unless "immediately" or "directly" is used, cases that are not continuous or sequential can also be included.

Although the terms first, second, and the like are used to describe various components, these components are not substantially limited by these terms. These terms are used only to distinguish one component from another component, and may not define any order or sequence. Therefore, a first component described below can substantially be a second component within the technical idea of the present disclosure.

Features of various embodiments of the present disclosure can be partially or entirely united or combined with each other, technically various interlocking and driving are possible, and each of the embodiments can be independently implemented with respect to each other or implemented together in a related relationship.

Hereinafter, example embodiments of the present disclosure will be described in detail with reference to accompanying drawings. All the components of each organic light-emitting diode display device according to all embodiments of the present disclosure are operatively coupled and configured. For example, although some components of the organic light-emitting diode display devices may not specifically described herein, the organic light-emitting diode display devices of the present disclosure include such components to fully and functionally operate.

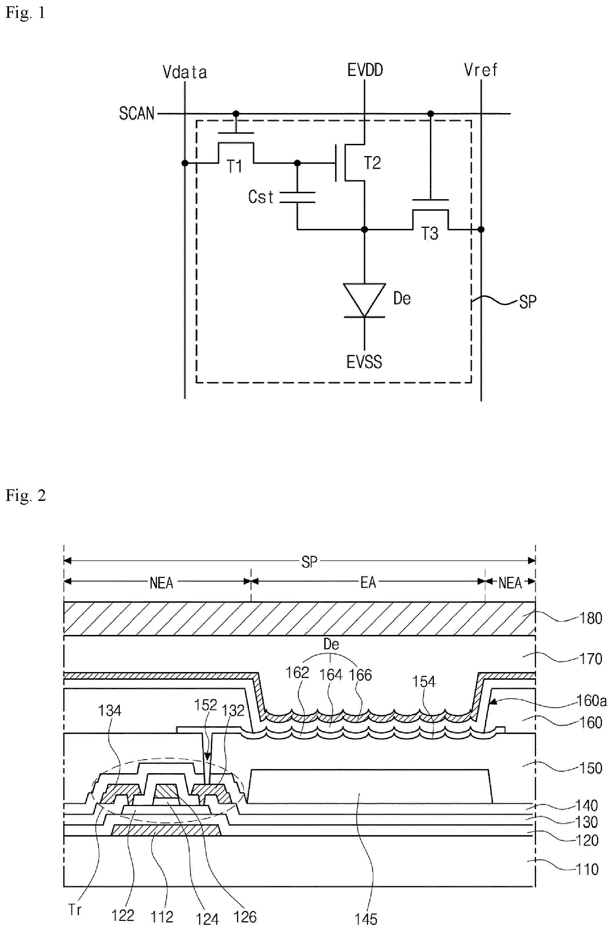

An organic light-emitting diode display device according to embodiments of the present disclosure includes a plurality of pixels arranged in the form of a matrix in a display area, and each pixel includes a plurality of sub-pixels. Each sub-pixel has the same or substantially the same configuration as other sub-pixels, and one example of the configuration of such sub-pixel will be described with reference to FIG. 1 and FIG. 2, but other configurations are possible.

FIG. 1 is an example of an equivalent circuit diagram of one sub-pixel of an organic light-emitting diode display device according to an embodiment of the present disclosure.

In FIG. 1, a sub-pixel SP of the organic light-emitting diode display device according to the embodiment of the present disclosure can include first, second, and third transistors T1, T2, and T3, a storage capacitor Cst, and a light-emitting diode De. The first, second, and third transistors T1, T2, and T3 can be a switching transistor T1, a driving transistor T2, and a sensing transistor T3, respectively. The switching transistor T1, the driving transistor T2, and the sensing transistor T3 can be n-type transistors. However, the present disclosure is not limited thereto. Alternatively, the switching transistor T1, the driving transistor T2, and the sensing transistor T3 can be p-type transistors or other types of transistors.

A gate line supplying a scan signal (or gate signal) SCAN and a data line supplying a data signal Vdata can cross each other, and the switching transistor T1 can be disposed at a crossing point of the gate line and the data line. A gate of the switching transistor T1 can be connected to the gate line to receive the gate signal SCAN, and a drain of the switching transistor T1 can be connected to the data line to receive the data signal Vdata.

In addition, a gate of the driving transistor T2 can be connected to a source of the switching transistor T1 and a first capacitor electrode of the storage capacitor Cst. A drain of the driving transistor T2 can be connected to a high potential line supplying a high potential voltage EVDD, and a source of the driving transistor T2 can be connected to an anode of the light-emitting diode De, a second capacitor electrode of the storage capacitor Cst, and a source of the sensing transistor T3.

A gate of the sensing transistor T3 can be connected to the gate line, and a drain of the sensing transistor T3 can be connected to a reference line supplying a reference voltage Vref. Alternatively, the gate of the sensing transistor T3 can be connected to a separate sensing line.

Here, source and drain locations of each of the transistors T1, T2, and T3 are not limited thereto, and the locations can be interchanged or varied.

Meanwhile, a cathode of the light-emitting diode De can be connected to a low potential line supplying a low potential voltage EVSS. Alternatively, the cathode of the light-emitting diode De can be connected to a ground voltage.

During an emission period of one frame, the switching transistor T1 can be switched according to the gate signal SCAN transmitted through the gate line to thereby provide the gate of the driving transistor T2 with the data signal Vdata transmitted through the data line. The driving transistor T2 can be switched according to the data signal Vdata to thereby control a current of the light-emitting diode De. In this case, the storage capacitor Cst can maintain charges corresponding to the data signal Vdata for one frame. Accordingly, even if the switching transistor T1 is turned off, the storage capacitor Cst can allow the amount of the current flowing through the light-emitting diode De to be constant and the gray level shown by the light-emitting diode De to be maintained until a next frame.

In addition, one frame can further include a sensing period. During the sensing period, the sensing transistor T3 can be switched according to the gate signal SCAN transmitted through the gate line to thereby provide the source of the driving transistor T2 with the reference voltage Vref. The sensing transistor T3 can detect the voltage change of the source of the driving transistor T2 through the reference line and can calculate the threshold voltage Vth of the driving transistor T2 by comparing the amount of the voltage change with a determination range. Accordingly, by calculating the threshold voltage Vth in real time and compensating for the image data, it is possible to compensate for the change in the characteristics of the driving transistor T2 and prevent image degradation.

FIG. 2 is a schematic cross-sectional view of the organic light-emitting diode display device according to the embodiment of the present disclosure. A cross-section corresponding to one sub-pixel is shown, and a bottom emission-type organic light-emitting diode display device will be described as an example and other variations are possible.

In FIG. 2, the organic light-emitting diode display device according to the embodiment of the present disclosure can include a plurality of sub-pixels each having a substrate 110, a thin film transistor Tr, and a light-emitting diode De.

A sub-pixel SP having an emission area EA and a non-emission area NEA can be provided over the substrate 110. The light-emitting diode De can be disposed in the emission area EA, and the thin film transistor Tr can be disposed in the non-emission area NEA.

Specifically, a light-shielding layer 112 can be disposed in the non-emission area NEA over the substrate 10. The substrate 110 can be formed of a transparent insulating material. For example, the substrate 110 can be a glass substrate or a plastic substrate. Polyimide can be used for the plastic substrate, but the embodiments of the present disclosure are not limited thereto.

The light-shielding layer 112 can be formed of at least one of aluminum (Al), copper (Cu), molybdenum (Mo), titanium (Ti), chromium (Cr), nickel (Ni), tungsten (W), or an alloy thereof and can have a single-layer structure or a multi-layer structure. For example, the light-shielding layer 112 can have a double-layer structure including a lower layer of a molybdenum-titanium (MoTi) alloy and an upper layer of copper (Cu), and the upper layer can have a thicker thickness than the lower layer. However, the embodiments of the present disclosure are not limited thereto.

A buffer layer 120 of an insulating material can be placed over the light-shielding layer 112. The buffer layer 120 can be disposed over substantially an entire surface of the substrate 110. The buffer layer 120 can be formed of an inorganic material such as silicon oxide (SiO₂) or silicon nitride (SiNx) and can have a single-layer structure or a multi-layer structure.

A semiconductor layer 122 can be patterned and placed over the buffer layer 120. The semiconductor layer 122 can overlap the light-shielding layer 112. The semiconductor layer 122 can be formed of an oxide semiconductor material. In this situation, the light-shielding layer 112 can block light incident on the semiconductor layer 122, thereby preventing the semiconductor layer 122 from being degraded due to the light.

Alternatively, the semiconductor layer 122 can be formed of polycrystalline silicon. In this situation, both ends of the semiconductor layer 122 can be doped with impurities.

A gate insulation layer 124 and a gate electrode 126 can be sequentially placed over the semiconductor layer 122. The gate insulation layer 124 and the gate electrode 126 can be disposed to correspond to a central portion of the semiconductor layer 122. The gate insulation layer 124 can be patterned to have substantially the same shape as the gate electrode 126. Alternatively, the gate insulation layer 124 can be disposed over substantially the entire surface of the substrate 110.

The gate insulation layer 124 can be formed of an inorganic insulating material such as silicon oxide (SiO₂) or silicon nitride (SiNx). Here, when the semiconductor layer 122 is formed of an oxide semiconductor material, the gate insulation layer 124 can be formed of silicon oxide (SiO₂). Alternatively, when the semiconductor layer 122 is formed of polycrystalline silicon, the gate insulation layer 124 can be formed of silicon oxide (SiO₂) or silicon nitride (SiNx).

The gate electrode 126 can be formed of a conductive material such as metal. For example, the gate electrode 126 can be formed of at least one of aluminum (Al), copper (Cu), molybdenum (Mo), titanium (Ti), chromium (Cr), nickel (Ni), tungsten (W), or an alloy thereof and can have a single-layer structure or a multi-layer structure. For example, the gate electrode 126 can have a double-layer structure including a lower layer of a molybdenum-titanium (MoTi) alloy and an upper layer of copper (Cu), and the upper layer can have a thicker thickness than the lower layer. However, the embodiments of the present disclosure are not limited thereto.

An interlayer insulation layer 130 of an insulating material can be disposed over the gate electrode 126 over substantially the entire surface of the substrate 110. The interlayer insulation layer 130 can be formed of an inorganic insulating material, such as silicon oxide (SiO₂) or silicon nitride (SiNx), or can be formed of an organic insulating material, such as photo acryl or benzocyclobutene.

The interlayer insulation layer 130 can have contact holes exposing top surfaces of both ends of the semiconductor layer 122. The contact holes can be disposed at both sides of the gate electrode 126 and can be spaced apart from the gate electrode 126.

Next, source and drain electrodes 132 and 134 of a conductive material such as metal can be placed over the interlayer insulation layer 130.

The source and drain electrodes 132 and 134 can be formed of at least one of aluminum (Al), copper (Cu), molybdenum (Mo), titanium (Ti), chromium (Cr), nickel (Ni), tungsten (W), or an alloy thereof and can have a single-layer structure or a multi-layer structure. For example, each of the source and drain electrodes 132 and 134 can have a double-layer structure including a lower layer of a molybdenum-titanium (MoTi) alloy and an upper layer of copper (Cu), and the upper layer can have a thicker thickness than the lower layer. Alternatively, the source and drain electrodes 132 and 134 can have a triple-layer structure. However, the embodiments of the present disclosure are not limited thereto. For example, transparent conductive materials can be used for the source and drain electrodes 132 and 134.

The source and drain electrodes 132 and 134 can be spaced apart from each other with the gate electrode 126 interposed therebetween and can be in contact with the both ends of the semiconductor layer 122 through the contact holes.

The semiconductor layer 122, the gate electrode 126, the source electrode 132, and the drain electrode 134 can constitute a thin film transistor Tr. Here, the thin film transistor Tr can have a coplanar structure in which the gate electrode 126 and the source and drain electrodes 132 and 134 are disposed at the same side with respect to the semiconductor layer 122, for example, the gate electrode 126 and the source and drain electrodes 132 and 134 can be disposed over the semiconductor layer 122.

Alternatively, the thin film transistor Tr can have an inverted staggered structure in which the gate electrode and the source and drain electrodes are disposed at different sides with respect to the semiconductor layer, for example, the gate electrode can be disposed under the semiconductor layer and the source and drain electrodes can be disposed over the semiconductor layer. In this case, the semiconductor can be formed of an oxide semiconductor material or amorphous silicon.

However, the embodiments of the present disclosure are not limited thereto. The stacked structure of the components of the thin film transistor Tr can be varied.

The thin film transistor Tr can be the driving transistor T2 of FIG. 1. Meanwhile, at least one thin film transistor having the same structure as the thin film transistor Tr, for example, the switching transistor T1 of FIG. 1 and the sensing transistor T3 of FIG. 1 can be further formed in the non-emission area NEA over the substrate 110. However, the embodiments of the present disclosure are not limited thereto. Alternatively, at least one thin film transistor having a different structure from the thin film transistor Tr can be further provided in the non-emission area NEA over the substrate 110.

A passivation layer 140 of an insulating material can be disposed over the source and drain electrodes 132 and 134 as well as the gate electrode 126 over substantially the entire surface of the substrate 110. The passivation layer 140 can be formed of an inorganic insulating material, such as silicon oxide (SiO₂) or silicon nitride (SiNx).

A color filter 145 can be placed over the passivation layer 140. The color filter 145 can be placed to correspond to the emission area EA and can be one of red, green, and blue color filters.

An overcoat layer 150 of an insulating material can be disposed over the color filter 145 over substantially the entire surface of the substrate 110. The overcoat layer 150 and the passivation layer 140 can have a source contact hole 152 exposing the source electrode 132.

The overcoat layer 150 can be formed of an organic insulating material. For example, the overcoat layer 150 can be formed of photo acryl. However, the embodiments of the present disclosure are not limited thereto.

The overcoat layer 150 can include a plurality of micro lenses 154 at a top surface thereof in the emission area EA. The plurality of micro lenses 154 can constitute a micro lens array (MLA), and each of the plurality of micro lenses 154 can have a depressed portion. Here, adjacent portions of two micro lenses 154 can form an embossed portion, and each depressed portion can be surrounded by the embossed portion. Accordingly, the micro lens array can be configured such that the depressed portion and the embossed portion can be alternately disposed or the micro lenses 154 can have other shapes and configurations.

Meanwhile, the overcoat layer 150 can have substantially a flat top surface in the non-emission area NEA.

A first electrode 162 of a conductive material having a relatively high work function can be placed over the overcoat layer 150 in the emission area EA. For example, the first electrode 162 can be formed of a transparent conductive material, such as indium tin oxide (ITO) or indium zinc oxide (IZO), but embodiments are not limited thereto.

The first electrode 162 can be extended into the non-emission area NEA and can be in contact with the source electrode 132 through the source contact hole 152.

In the emission area EA, the first electrode 162 can be formed along the morphology or contour of the top surface of the overcoat layer 150 including the micro lenses 154. Accordingly, the first electrode 162 can have an uneven top surface.

A bank 160 of an insulating material can be placed over the first electrode 162. The bank 160 can be formed of an organic insulating material. The bank 160 can overlap and cover edges of the first electrode 162. The bank 160 can have an opening 160a corresponding to the emission area EA, and a central portion of the first electrode 162 can be exposed through the opening 160a.

Next, a light-emitting layer 164 can be placed over the first electrode 162 exposed through the opening 160a of the bank 160. The light-emitting layer 164 can be disposed over substantially the entire surface of the substrate 110. Accordingly, in the emission area EA, the light-emitting layer 164 can be disposed over the first electrode 162 and in contact with the first electrode 162. In the non-emission area NEA, the light-emitting layer 164 can be disposed over the bank 160 and in contact with a top surface of the bank 160. Further, the light-emitting layer 164 can be in contact with a side surface of the bank 160.

The light-emitting layer 164 can emit white light and can include at least one hole auxiliary layer, at least one light-emitting material layer, and at least one electron auxiliary layer, which constitute one light-emitting unit. The hole auxiliary layer can include at least one of a hole injection layer (HIL) and a hole transport layer (HTL). In addition, the electron auxiliary layer can include at least one of an electron injection layer (EIL) and an electron transport layer (ETL). But embodiments of the present disclosure are not limited thereto, as other functional layers can be used.

The light-emitting layer 164 can have a stack structure in which two or more light-emitting units emitting different colors are stacked, and a charge generation layer can be provided between two or more light-emitting units.

In the emission area EA, the light-emitting layer 164 can be formed along the morphology or contour of the top surface of the first electrode 162. Accordingly, in the emission area EA, the light-emitting layer 164 can be formed substantially along the morphology or contour of the top surface of the overcoat layer 150, and the light-emitting layer 164 can have an uneven top surface.

Here, the light-emitting layer 164 can have different thicknesses depending on the position. For example, a thickness of a portion of the light-emitting layer 164 corresponding to the depressed portion of the micro lens 154 can be thicker than a thickness of a portion of the light-emitting layer 164 corresponding to the embossed portion where two micro lenses 154 are adjacent to each other, and the light-emitting layer 164 can have the thinnest thickness between the depressed portion and the embossed portion.

A second electrode 166 of a conductive material, having a relatively low work function, can be placed over the light-emitting layer 164 over substantially the entire surface of the substrate 110. In the emission area EA, the second electrode 166 can be disposed over the first electrode 162 and the light-emitting layer 164, and in the non-emission area NEA, the second electrode 166 can be disposed over the bank 160 and the light-emitting layer 164.

The second electrode 166 can be formed of aluminum, magnesium, silver, or an alloy thereof.

In the emission area EA, the second electrode 166 can be formed along the morphology or contour of the top surface of the light-emitting layer 164. Accordingly, in the emission area EA, the second electrode 166 can be formed substantially along the morphology or contour of the top surface of the overcoat layer 150 including the micro lenses 154, and the second electrode 166 can have an uneven top surface.

The first electrode 162, the light-emitting layer 164, and the second electrode 166 can constitute the light-emitting diode De. Here, the first electrode 162 can function as an anode, and the second electrode 166 can function as a cathode, but the embodiments are not limited thereto.

The first electrode 162 can be formed of a transparent conductive material transmitting light, and the second electrode 166 can be formed of a metal material reflecting light. Accordingly, light from the light-emitting layer 164 can be emitted through the first electrode 162 and can pass through the color filter 145 and the substrate 110 to be output to the outside.

An encapsulation layer 170 can be placed over the second electrode 166 over substantially the entire surface of the substrate 110. The encapsulation layer 170 can be in the form of a face seal made of an organic or inorganic insulating material that is transparent and has adhesive properties or can have a multi-layer structure in which an inorganic layer, an organic layer, and an inorganic layer are stacked.

A counter substrate 180 can be placed over the encapsulation layer 170. The counter substrate 180 can be a glass substrate or a metal substrate. Alternatively, the counter substrate 180 can be formed in the form of a film.

The encapsulation layer 170 and the counter substrate 180 can prevent substances such as moisture, dust or oxygen from being introduced into the light-emitting diode De from the outside or prevent an external impact from being applied to the light-emitting diode De.

As described above, the overcoat layer 150 can have the plurality of micro lenses 154 at the top surface thereof in the emission area EA, and the first electrode 162, the light-emitting layer 164, and the second electrode 166 placed over the overcoat layer 150 can be formed substantially along the morphology or contour of the top surface of the overcoat layer 150. Accordingly, in the emission area EA, the first electrode 162, the light-emitting layer 164, and the second electrode 166 can have uneven patterns corresponding to the micro lenses 154 of the overcoat layer 150. Further, in the emission area EA, the first electrode 162, the light-emitting layer 164, and the second electrode 166 can also have micro lenses.

The micro lenses 154 can improve the light extraction efficiency by changing the progress path of light so that the light, which was completely reflected and extinguished after being emitted from the light-emitting layer, can be extracted to the outside.

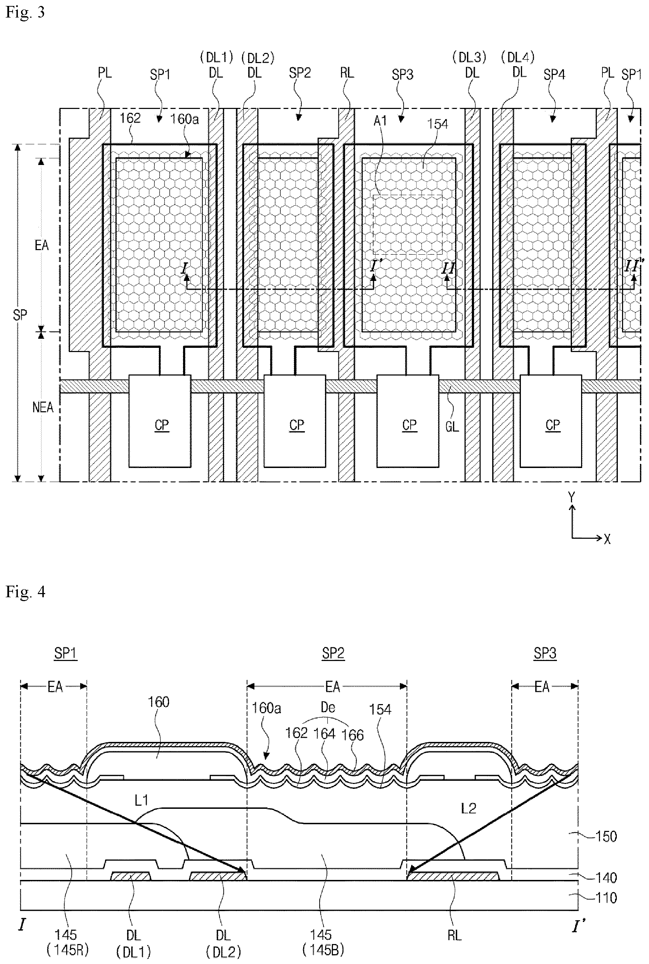

In the organic light-emitting diode display device according to the embodiments of the present disclosure, signal lines placed under the bank can be differently designed for each sub-pixel. A first embodiment of the present disclosure can be described with reference to FIG. 3.

FIG. 3 is a schematic plan view of an organic light-emitting diode display device according to a first embodiment of the present disclosure, showing one pixel and will be described with reference to FIG. 1 and FIG. 2 together.

As shown in FIG. 3, in the organic light-emitting diode display device according to the first embodiment of the present disclosure, a gate line GL, as a horizontal line, can extend along a first direction, which is the X direction, and data lines DL, power lines PL, and a reference line RL, as vertical lines, can extend along a second direction, which is the Y direction. The gate line GL can cross the data line DL, the power line PL, and the reference line RL to thereby define a plurality of sub-pixels SP. Here, the power line PL can be the high potential line supplying the high potential voltage EVDD of FIG. 1.

Here, one reference line RL can be disposed between two power lines PL, two data lines DL can be disposed between one power line PL and one reference line RL, and each sub-pixel SP can be disposed substantially between one power line PL and one adjacent data line DL or between one reference line RL and one adjacent data line DL.

Each sub-pixel SP can have substantially a rectangular shape. However, the embodiments of the present disclosure are not limited thereto, and the shape of each sub-pixel SP can be changed.

As described above, one pixel can include a plurality of such sub-pixels SP. For example, one pixel can include four sub-pixels SP, for example, first, second, third, and fourth sub-pixels SP1, SP2, SP3, and SP4.

One power line PL and one reference line RL can be provided to correspond to one pixel, and one data line DL can be provided to correspond to one sub-pixel SP. Accordingly, the data lines DL can include first, second, third, and fourth data lines DL1, DL2, DL3, and DL4 corresponding to the first, second, third, and fourth sub-pixels SP1, SP2, SP3, and SP4, respectively.

The first, second, third, and fourth sub-pixels SP1, SP2, SP3, and SP4 can be sequentially arranged along the first direction. Here, the first sub-pixel SP1 can be a red sub-pixel, the second sub-pixel SP2 can be a blue sub-pixel, the third sub-pixel SP3 can be a white sub-pixel, and the fourth sub-pixel SP4 can be a green sub-pixel. However, the embodiments of the present disclosure are not limited thereto. Alternatively, the number of sub-pixels included in one pixel or the arrangement order of the red, green, blue, and white sub-pixels can be changed.

The areas or sizes of the first, second, third, and fourth sub-pixels SP1, SP2, SP3, and SP4 can be different from each other. For example, the areas of the first and third sub-pixels SP1 and SP3 can be larger than the areas of the second and fourth sub-pixels SP2 and SP4. In addition, the area of the third sub-pixel SP3 can be equal to or larger than the area of the first sub-pixel SP1, and the area of the second sub-pixel SP2 can be equal to or larger than the area of the fourth sub-pixel SP4. However, the embodiments of the present disclosure are not limited thereto. Alternatively, all areas or sizes of the first, second, third, and fourth sub-pixels SP1, SP2, SP3, and SP4 can be the same or substantially the same.

Here, one power line PL, two data lines DL, or one reference line RL can be disposed substantially between adjacent two of the sub-pixels SP1, SP2, SP3, and SP4. For example, two data lines DL can be disposed between the first and second sub-pixels SP1 and SP2 and between the third and fourth sub-pixels SP3 and SP4, that is, the first and second data lines DL1 and DL2 between the first and second sub-pixels SP1 and SP2 and the third and fourth data lines DL3 and DL4 between the third and fourth sub-pixels SP3 and SP4, one reference line RL can be disposed between the second and third sub-pixels SP2 and SP3, and one power line PL can be disposed between the first sub-pixel SP1 and a fourth sub-pixel SP4 of a previous pixel and between the fourth sub-pixel SP4 and a first sub-pixel SP1 of a next pixel. However, the embodiments of the present disclosure are not limited thereto.

Each sub-pixel SP can include the emission area EA and the non-emission area NEA. The light-emitting diode De of FIG. 1 can be provided in the emission area EA, and a circuit portion CP can be provided in the non-emission area NEA. The light-emitting diode De can include the first electrode 162, which is an anode, and the circuit portion CP can include the first, second, and third transistors T1, T2, and T3 and the storage capacitor Cst of FIG. 1.

The first electrode 162 can extend into the non-emission area NEA and can be electrically connected to the circuit portion CP. More particularly, the first electrode 162 can be electrically connected to the second transistor T2 of the circuit portion CP.

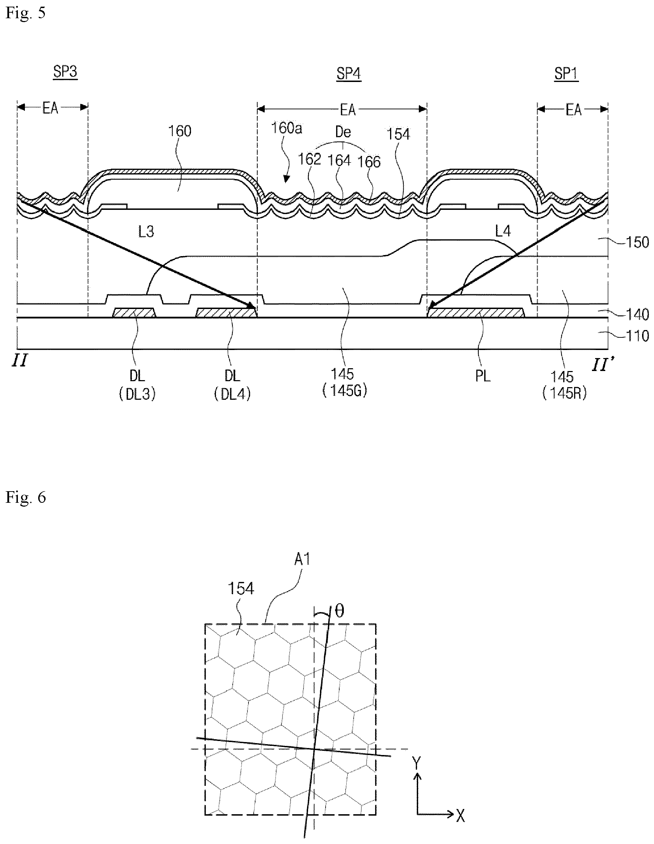

The emission area EA can be defined by the opening 160a of the bank (e.g., 160 in FIGS. 4 and 5) exposing the first electrode 162. The opening 160a of the bank can have a smaller area than the first electrode 162 and can be disposed within the edges of the first electrode 162.

Here, each of the power lines PL, the data lines DL, and the reference line RL can overlap the first electrode 162 corresponding thereto. In this case, each of the power lines PL and the reference line RL can include a portion overlapping the first electrode 162, which has a wider width than other portions of the corresponding power line PL or reference line RL. However, the embodiments of the present disclosure are not limited thereto. For example, the wider width of the power line PL or the reference line RL extends in the second direction to overlap the first electrode 162 of the fourth sub-pixel SP4 or the first electrode 162 of the second sub-pixel SP2. In this context, a length of the wider width of the power line PL or the reference line RL in the second direction can be longer than those of the first electrodes 162 of the fourth sub-pixel SP4 or the second sub-pixel SP2. However, embodiments of the present disclosure are not limited thereto, and the length of the wider width of the power line PL or the reference line RL in the second direction can be equal to or less than those of the first electrodes 162 of the fourth sub-pixel SP4 or the second sub-pixel SP2.

In addition, each of the power lines PL, the data lines DL, and the reference line RL can be spaced apart from the opening 160a of the bank corresponding thereto or can have a side, which substantially coincides with an edge of the opening 160a.

Specifically, the opening 160a of the first sub-pixel SP1 can be spaced apart from the power line PL and the first data line DL1 adjacent thereto. The opening 160a of the second sub-pixel SP2 can have edges, which face each other and coincide with one sides of the second data line DL2 and the reference line RL adjacent thereto, respectively. The opening 160a of the third sub-pixel SP3 can be spaced apart from the reference line RL and the third data line DL3 adjacent thereto. The opening 160a of the fourth sub-pixel SP4 can have edges, which face each other and coincide with one sides of the fourth data line DL4 and the power line PL adjacent thereto, respectively. But embodiments of the present disclosure are not limited thereto. In other embodiments of the present disclosure, the edges of the openings 160a of the second sub-pixel SP2 and the edges of the openings 160a of the fourth sub-pixel SP4 can be not coinciding with the second data line DL2, the fourth data line DL4, the reference line RL or the power line PL. For example, the edges of the openings can be separated from the various lines, or can even overlap with the various lines. If separated from the various lines, space or gap between the edges of the openings 160a of the second sub-pixel SP2 or the fourth sub-pixel SP4 and the various lines can be less than those of the edges of the openings 160a of the first sub-pixels SP2 or the third sub-pixels SP3.

Accordingly, a width of the opening 160a of the first sub-pixel SP1 along the first direction can be smaller than a distance between the power line PL and the first data line DL1 adjacent thereto. A width of the opening 160a of the second sub-pixel SP2 along the first direction can be equal to a distance between the second data line DL2 and the reference line RL adjacent thereto. A width of the opening 160a of the third sub-pixel SP3 along the first direction can be smaller than a distance between the reference line RL and the third data line DL3 adjacent thereto. A width of the opening 160a of the fourth sub-pixel SP4 along the first direction can be equal to a distance between the fourth data line DL4 and the power line PL adjacent thereto.

In addition, at least a portion of the second and fourth data lines DL2 and DL4 can have a wider width than the first and third data lines DL1 and DL3.

A plurality of micro lenses 154 can be provided in the emission area EA of each sub-pixel SP. The micro lenses 154 can be placed inside the opening 160a of the bank but also outside the opening 160a and can overlap the bank. Meanwhile, the micro lenses 154 can overlap the first electrode 162 and can be spaced apart from the edges of the first electrode 162 without overlapping.

The micro lenses 154 can have a hexagonal shape in a plan view and can form a honeycomb structure. Alternatively, the micro lenses 154 can have a circular shape, an oval shape, a rectangular shape, or the like. But embodiments of the present disclosure are not limited thereto.

Further, with reference to FIG. 3, although the first electrodes 162 of the first, second, third and fourth sub-pixels SP1, SP2, SP3 and PS4 are shown coinciding at upper and lower edges in the figure, embodiments of the present disclosure are not limited thereto. For example, the edge of the first electrode 162 of the first sub-pixel SP 1 need not coincide with the edge of the first electrode 162 of the second sub-pixel SP2 or to that of any other, so that edges of the first electrodes 162 of the first through fourth sub-pixels SP1-SP4 can all be misaligned. Accordingly, in various embodiments of the present disclosure, edges of the first electrodes 162 of one, two, three or four of the first through fourth sub-pixels SP1-SP4 can coincide.

Further, with reference to FIG. 3, widths of the openings 160a or the first electrodes 162 of the first through fourth sub-pixels SP1-SP4 sequentially arranged along the first direction alternate between longer and shorter in dimensions. For example, the second sub-pixel SP2 having the opening 160a and the first electrode 162 having a relatively shorter width that those of the first sub-pixel SP1 and the third sub-pixel SP3 is located between the first sub-pixel SP1 and the third sub-pixel SP3. A similar arrangement is provided for the fourth sub-pixel SP4. Accordingly, that arrangement of the first through fourth sub-pixels SP1-SP4 along the first direction is varied to provide increase variability in the patterns of the sub-pixels SP1-SP4 without increasing randomness.

The cross-sectional structure of the organic light-emitting diode display device according to the first embodiment of the present disclosure will be described with reference to FIG. 4 and FIG. 5.

FIG. 4 is a cross-sectional view corresponding to the line I-I' of FIG. 3, and FIG. 5 is a cross-sectional view corresponding to the line II-II' of FIG. 3. FIG. 4 and FIG. 5 will be described with reference to FIG. 3 together.

In FIG. 4 and FIG. 5, the substrate 110 can include the plurality of sub-pixels, for example, the first, second, third, and fourth sub-pixels SP1, SP2, SP3, and SP4. The power lines PL, the data lines DL, and the reference line RL, which are a first conductive layer, can be placed over the substrate 110. The passivation layer 140 can be sequentially placed over the power lines PL, the data lines DL, and the reference line RL.

The data lines DL can include the first, second, third, and fourth data lines DL1, DL2, DL3, and DL4 corresponding to the first, second, third, and fourth sub-pixels SP1, SP2, SP3, and SP4, respectively. Here, the first and third data lines DL1 and DL3 can have substantially the same width, and the second and fourth data lines DL2 and DL4 can have substantially the same width. The width of the second and fourth data lines DL2 and DL4 can be wider than that of the first and third data lines DL1 and DL3.

Although not shown in the figures, at least one insulation layer can be further provided between the substrate 110 and the passivation layer 140. For example, a buffer layer can be further placed between the first conductive layer PL, DL, and RL and the passivation layer 140. Moreover, the gate line GL, which is a second conductive layer, can be placed between the buffer layer and the passivation layer 140, and a gate insulation layer can be further provided under the gate line GL.

Next, the color filter 145 can be placed over the passivation layer 140 corresponding to the emission area EA. The color filter 145 can include red, green, and blue color filters 145R, 145G, and 145B. The red color filter 145R can be disposed in the first sub-pixel SP1, the blue color filter 145B can be disposed in the second sub-pixel SP2, and the green color filter 145G can be disposed in the fourth sub-pixel SP4. No color filter can be disposed in the third sub-pixel SP3 which can be a white sub-pixel. Accordingly, the first, second, third, and fourth sub-pixels SP1, SP2, SP3, and SP4 can emit red light, blue light, white light, and green light, respectively.

The color filter 145 can overlap the signal lines adjacent thereto. For instance, the red color filter 145R can overlap one power line PL and the first data line DL1, the blue color filter 145B can overlap the second data line DL2 and the reference line RL, and the green color filter 145G can overlap the fourth data line DL4 and another power line PL.

In addition, adjacent ones of the red, blue, and green color filters 145R, 145B, and 145G can overlap each other. For example, adjacent red and blue color filters 145R and 145B can overlap each other, and adjacent green and red color filters 145G and 145R can overlap each other. In this case, the red color filter 145R can also overlap the second data line DL2, and the green color filter 145G can also overlap the third data line DL3. However, the embodiments of the present disclosure are not limited thereto. Alternatively, the adjacent ones of the red, blue, and green color filters 145R, 145B, and 145G can be spaced apart from each other.

The overcoat layer 150 can be placed over the color filter 145. The overcoat layer 150 can have the plurality of micro lenses 154 at the top surface thereof in the emission area EA of each sub-pixel SP1, SP2, SP3, and SP4.

In the first, second, and fourth sub-pixels SP1, SP2, and SP4, the micro lenses 154 can overlap the color filter 145. Each micro lens 154 can include the depressed portion, and adjacent portions of two or more micro lenses 154 can form the embossed portion.

Next, the first electrode 162 of the light-emitting diode De can be placed over the overcoat layer 150 in each of the first, second, third, and fourth sub-pixels SP1, SP2, SP3, and SP4. The first electrode 162 can overlap and cover the micro lenses 154.

The first electrode 162 can overlap the signal lines adjacent thereto. Specifically, the first electrode 162 of the first sub-pixel SP1 can overlap the power line PL and the first data line DL1 adj acent thereto. The first electrode 162 of the second sub-pixel SP2 can overlap the second data line DL2 and the reference line RL adjacent thereto. The first electrode 162 of the third sub-pixel SP3 can overlap the reference line RL and the third data line DL3 adjacent thereto. The first electrode 162 of the fourth sub-pixel SP4 can overlap the fourth data line DL4 and the another power line PL adj acent thereto. In embodiments of the present disclosure, with reference to FIG. 3 also, the reference line RL and the power line PL can each overlap with two of the first electrodes 162 of a subpixel that are immediately adjacent thereto. For example, the reference line RL can overlap with the first electrodes 162 of the second sub-pixel SP2 and the third sup-pixel SP3, and the power line PL can overlap with the first electrodes 162 of the fourth sub-pixel SP4 and the first sub-pixel SP1. Meanwhile, the first electrode 162 of the first sub-pixel SP1 can overlap individually with the first data line DL1 while the first electrode 162 of the second sub-pixel can overlap individually with the second data line DL2. Similarly, the first electrode 162 of the third sub-pixel SP3 can overlap individually with the third data line DL3 and the first electrode 162 of the fourth sub-pixel SP3 can overlap individually with the fourth data line DL4.

The bank 160 can be provided over the first electrode 162. The bank 160 can have the opening 160a corresponding to the emission area EA of each sub-pixel SP1, SP2, SP3, and SP4. The first electrode 162 can be exposed through the opening 160a. The opening 160a of the bank 160 can define the emission area EA, and the width and area of the opening 160a can be substantially the same as the width and area of the emission area EA.

The bank 160 can overlap the micro lenses 154 in each of the first, second, third, and fourth sub-pixels SP1, SP2, SP3, and SP4. In this case, the bank 160 can overlap a portion of the micro lens 154.

Here, edges of the opening 160a of the first sub-pixel SP1, that is, two side surfaces of the bank 160 corresponding to the first sub-pixel SP1, which face each other, can be spaced apart from the power line PL and the first data line DL1 adjacent thereto. Accordingly, the width of the opening 160a of the first sub-pixel SP1, that is, the width of the emission area EA of the first sub-pixel SP1 can be smaller than the distance between the power line PL and the first data line DL1 adjacent thereto.

Edges of the opening 160a of the second sub-pixel SP2, that is, two side surfaces of the bank 160 corresponding to the second sub-pixel SP2, which face each other, can coincide with the one sides of the second data line DL2 and the reference line RL adjacent thereto, respectively. Accordingly, the width of the opening 160a of the second sub-pixel SP2, that is, the width of the emission area EA of the second sub-pixel SP2 can be the same as the distance between the second data line DL2 and the reference line RL adjacent thereto.

Edges of the opening 160a of the third sub-pixel SP3, that is, two side surfaces of the bank 160 corresponding to the third sub-pixel SP3, which face each other, can be spaced apart from the reference line RL and the third data line DL3 adjacent thereto. Accordingly, the width of the opening 160a of the third sub-pixel SP3, that is, the width of the emission area EA of the third sub-pixel SP3 can be smaller than the distance between the reference line RL and the third data line DL3 adjacent thereto.

Edges of the opening 160a of the fourth sub-pixel SP4, that is, two side surfaces of the bank 160 corresponding to the fourth sub-pixel SP4, which face each other, can coincide with the one sides of the fourth data line DL4 and the another power line PL adjacent thereto, respectively. Accordingly, the width of the opening 160a of the fourth sub-pixel SP4, that is, the width of the emission area EA of the fourth sub-pixel SP4 can be the same as the distance between the fourth data line DL4 and the another power line PL adjacent thereto.

The light-emitting layer 164 of the light-emitting diode De can be placed over the first electrode 162 and the bank 160. The light-emitting layer 164 can be disposed over substantially the entire surface of the substrate 110. The light-emitting layer 164 can emit white light and can have a stack structure, which includes light-emitting units emitting different colors.

The second electrode 166 can be placed over the light-emitting layer 164. The second electrode 166 can be disposed over substantially the entire surface of the substrate 110.

The first electrode 162, the second electrode 166, and the light-emitting layer 164 interposed therebetween can constitute the light-emitting diode De.

As described above, the overcoat layer 150 can have the micro lenses 154 at its top surface in the emission area EA. The first electrode 162, the light-emitting layer 164, and the second electrode 166 disposed over the overcoat layer 150 can be formed along the morphology or contour of the top surface of the overcoat layer 150. Accordingly, the first electrode 162, the light-emitting layer 164, and the second electrode 166 can also have the micro lens shape at the respective top surfaces in the emission area EA, and the micro lenses 154 can change the progress path of light, thereby improving the light extraction efficiency.

In the organic light-emitting diode display device according to the first embodiment of the present disclosure, the signal lines under the bank 160 adjacent to the second and fourth sub-pixels SP2 and SP4 emitting blue light and green light, that is, the second data line DL2, the reference line RL, the fourth data line DL4, and the another power line PL can be configured to have an increased width than before, so that one ends of the signal lines DL2, RL, DL4, and PL can correspond to the edges of the openings 160a of the second and fourth sub-pixels SP2 and SP4. Accordingly, it is possible to prevent vertical stripe-shaped stains in the second and fourth sub-pixels SP2 and SP4 emitting blue light and green light.

Specifically, at the top surfaces of the color filter 145 and the overcoat layer 150 disposed over the signal lines PL, DL, and RL, a step portion in which heights are different from the substrate 110 can occur depending on the heights of the signal lines PL, DL, and RL. When the step portion is located under the bank 160, the bank material can flow into the opening 160a and fill the micro lenses 154 in the process of forming the bank 160. At this time, the amount of the bank material filling the micro lenses 154 may not be uniform between the micro lenses 154, and this can appear as the vertical stripe-shaped stains.

The vertical stripe-shaped stains are not well recognized in the first and third sub-pixels SP1 and SP3 emitting red light and white light, while they are well recognized in the second and fourth sub-pixels SP2 and SP4 emitting blue light and green light, thereby causing a decrease in image quality. Therefore, in the organic light-emitting diode display device according to the first embodiment of the present disclosure, by increasing the widths of the signal lines under the bank 160 adjacent to the second and fourth sub-pixels SP2 and SP4 emitting blue light and green light, that is, the second data line DL2, the reference light RL, the fourth data line DL4, and the another power line PL, the step portion of the color filter 145 and the overcoat layer 150 can be spaced apart from the bank 160. Namely, the step portion can be disposed within the opening 160a. As a result, the bank 160 can be prevented from flowing due to the step portion, thereby increasing the uniformity of the bank 160 and preventing the vertical stripe-shaped stains.

In addition, the second data line DL2, the reference line RL, the fourth data line DL4, and the another power line PL with the increased widths can prevent light leakage by blocking light incident from the adjacent sub-pixels.

Specifically, first light L1 incident from the first sub-pixel SP1 to the second sub-pixel SP2 can be blocked by the second data line DL2, and second light L2 incident from the third sub-pixel SP3 to the second sub-pixel SP2 can be blocked by the reference line RL, thereby preventing light leakage in the second sub-pixel SP2. Further, third light L3 incident from the third sub-pixel SP3 to the fourth sub-pixel SP4 can be blocked by the fourth data line DL4, and fourth light L4 incident from a first sub-pixel SP1 of the adjacent pixel to the fourth sub-pixel SP4 can be blocked by the another power line PL, thereby preventing light leakage in the fourth sub-pixel SP4.

Moreover, the second data line DL2, the reference line RL, the fourth data line DL4, and the another power line PL with the increased widths can reflect the light trapped inside by total reflection after being emitted from the light-emitting diodes De of the corresponding sub-pixels, that is, the second and fourth sub-pixels SP2 and SP4 and output it to the outside, thereby further increasing the light extraction efficiency and improving the luminance.

In the above embodiment, although the widths of the signal lines DL2, RL, DL4, and PL adjacent to the second and fourth sub-pixels SP2 and SP4 have been described as increasing, the embodiments of the present disclosure are not limited thereto. The widths of the signal lines adjacent to at least one of the sub-pixels SP1, SP2, SP3, and SP4 can be increased such that one sides of the signal lines with the increased widths can coincide with the edges of the openings 160a of the corresponding sub-pixels SP1, SP2, SP3, and SP4. Accordingly, in some embodiments, the widths of the signal lines PL, DL1, RL, and DL3 adjacent to the first and third sub-pixels SP1 and SP3, so that the one sides of the signal lines PL, DL1, RL, and DL3 can coincide with the edges of the openings 160a of the corresponding first and third sub-pixels SP1 and SP3. Regarding the step portion in which heights of the top surfaces of the color filter 145 or the overcoat layer 150 disposed over the signal lines PL, DL, and RL are different with respect to the substrate 110, the heights of the color filters 145 can be the same or vary. For example, with reference to FIGS. 4 and 5, a height of one color filter 145 can be different from a height of another color filter 145. In FIG. 4, the height of the red color filter 145R can be less than the height of the blue color filter 145B. The height difference between the red color filter 145R and the blue color filter 145B can be located at the bank 160, and over at least one of the first data line DL1 and the second data line DL2. A corresponding structure can be found between the green color filter 145G and the red color filter 145R over the power line PL in FIG. 5. The step portion can extend from the bank 160 to a at least a portion of the emission area EA of the second sub-pixel SP2 in FIG. 4 or the emission area EA of the fourth sub-pixel SP4 in FIG. 5. In addition to uplifting by the presence of the data lines DL, the power line PL or the reference line RL at the bank 160, the step portion can occur due to the overlap between adjacent color filters 145, such as the overlap of the red color filter 145R and the blue color filter 145B or the overlap of the green color filter 145G and the red color filter 145R, but embodiments of the present disclosure is not limited thereto. For example, there need not be an overlap between adjacent color filters 145 in various embodiments of the present disclosure. For example, the adjacent color filters 145 can simply touch each other without overlapping. Further, the top surfaces of the adjacent color filters 145 can coincide and can have the same or approximately the same height.

Meanwhile, in another embodiment of the present disclosure, the micro lenses in at least one sub-pixel can be provided to be rotated. Such a second embodiment of the present disclosure will be described with reference to FIG. 6. The second embodiment is substantially the same as the first embodiment, but the micro lenses in at least one sub-pixel can be rotated.

FIG. 6 is a schematic plan view of an organic light-emitting diode display device according to the second embodiment of the present disclosure and is an enlarged view corresponding to the area A1 of FIG. 3. The first to fourth sub-pixels can be sequentially provided over the substrate 110.

In FIG. 6, the micro lenses 154 provided in at least one sub-pixel can be rotated clockwise or counterclockwise with respect to the first and second directions. Here, the first direction is the X direction, and the second direction is the Y direction.

For example, the micro lenses 154 can be rotated clockwise with an angle θ with respect to the first and second directions. Accordingly, the line connecting the centers of the micro lenses 154 adjacent to each other can have the angle θ with respect to the first and/or second direction.

Here, the angle θ can be selected from a range greater than or equal to 0 degrees and less than 60 degrees. For instance, the rotation angle of the micro lenses 154 can be between 0 to 60 degrees in the clockwise or counterclockwise direction.

Further, the micro lenses 154 of all or some sub-pixels can be rotated. In this case, the micro lenses 154 of the adjacent sub-pixels can have different rotation angles.

For example, the micro lenses 154 in twenty sub-pixels arranged in a matrix form can be rotated clockwise or counterclockwise with a rotation angle of 3 degree difference and randomly arranged. However, the embodiments of the present disclosure are not limited thereto.

As such, in the organic light-emitting diode display device according to the second embodiment of the present disclosure, the micro lenses 154 in at least one sub-pixel can be disposed to be rotated at a specific angle with respect to the first and second directions. Accordingly, the diffraction pattern of the reflected light generated by the regular arrangement of the micro lenses 154 can be offset or minimized, or the diffraction pattern of the reflected light can be irregular or random, so the occurrence of a radial rainbow pattern or a radial circular ring pattern of the reflected light can be suppressed or minimized. Therefore, the image quality of the display device can be improved.

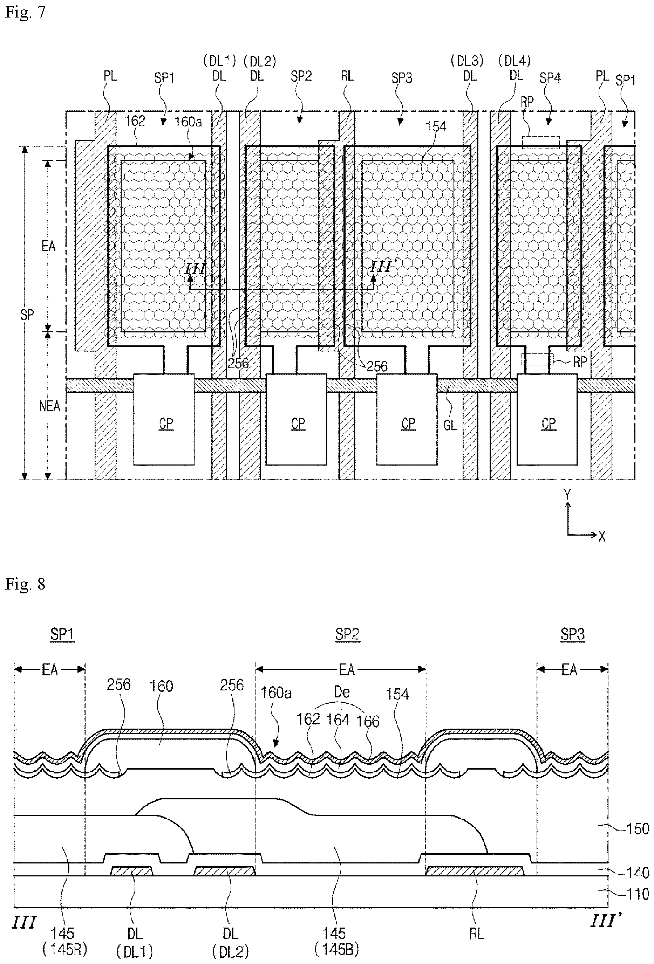

In another embodiment of the present disclosure, the organic light-emitting diode display device can include at least one dummy lens outside the opening. An organic light-emitting diode display device according to such a third embodiment of present disclosure will be described with reference to FIG. 7 and FIG. 8.

FIG. 7 is a schematic plan view of an organic light-emitting diode display device according to the third embodiment of the present disclosure, and FIG. 8 is a cross-sectional view corresponding to the line III-III' of FIG. 7. The organic light-emitting diode display device according to the third embodiment of the present disclosure has substantially the same configuration as that of the first embodiment or the second embodiment, except for having at least one dummy lens. The same or similar parts as the first or second embodiment will be designated by the same or similar references, and explanation for the same parts will be omitted or shortened.

As shown in FIG. 7 and FIG. 8, in the organic light-emitting diode display device according to the third embodiment of the present disclosure, at least one dummy lens 256 can be provided outside the opening 160a of each of the first, second, third, and fourth sub-pixels SP1, SP2, SP3, and SP4. That is, the dummy lens 256 can be provided in the non-emission area NEA between the emission areas EA.

The dummy lens 256 can be spaced apart from the opening 160a and disposed under the bank 160. The dummy lens 256 can entirely overlap the bank 160. In addition, the dummy lens 256 can overlap the signal lines PL, DL, and RL thereunder. In the first, second, and fourth sub-pixels SP1, SP2, and SP4, the dummy lens 256 can also overlap the color filter 145.

Here, the dummy lens 256 can be provided only on left and right sides of the opening 160a, that is, on opposite sides of the opening 160a facing each other along the first direction and may not be provided on upper and lower sides of the opening 160a, that is, on opposite sides of the opening 160a facing each other along the second direction. Accordingly, the dummy lens 256 can overlap left and right edges of the first electrode 162 facing each other along the first direction and be spaced apart from upper and lower edges of the first electrode facing each other along the second direction.

The dummy lens 256 can have the same size and shape as the micro lenses 154. Alternatively, the dummy lens 256 can have a different size and shape from the micro lenses 154. For example, the size of the dummy lens 256 can be larger than the size of the micro lens 154 or can have a greater depth than those of the micro lenses 154. However, the embodiments of the present disclosure are not limited thereto. For example, the depth of the dummy lens 256 can be shallower than the those of the micro lenses 154. Additionally, the dummy lens 256 need not be lacking under the bank 160 but can continue from one side of the bank 160 to the opposite side of the bank 160 continuously or only periodically. If periodic, several dummy lenses 256 separated from each other can be present under the bank 160.

The dummy lens 256 can prevent the vertical stripe-shaped stains that can be caused by the bank 160.

Specifically, the dummy lens 256 can function as a dam in which the bank material is pre-filled in the process of forming the bank 160, so that the bank material can be uniformly spread. Accordingly, the bank material can be prevented from flowing into the opening 160a and filling the micro lenses 154 unevenly, and it is possible to further improve the vertical stripe-shaped stains.

As described above, the dummy lens 256 can be provided only on the left and right sides of the opening 160a and not provided on the upper and lower sides of the opening 160a. This is to prevent the occurrence of an electrical short during a repair process due to defects.

More particularly, when defects occur in at least one sub-pixel, for example, in the fourth sub-pixels, as shown in FIG. 7, repair points RP corresponding to upper and lower ends of the first electrode 162 can be cut by a laser and repaired.

However, if the dummy lens 256 is provided on the upper and lower sides of the opening 160a, the dummy lens 256 can be located on the repair points RF, and thus, the electrical short can occur during the repair process.

Accordingly, in the present disclosure, by providing the dummy lens 256 only on the left and right sides of the opening 160a and not providing the dummy lens 256 on the upper and lower sides of the opening 160a, the repair performance can be improved, and the risk of the electrical short can be prevented.

As such, in the organic light-emitting diode display device according to the third embodiment of the present disclosure, by providing the at least one dummy lens 256 right under the bank 160 and completely overlapping the bank 160, the vertical stripe-shaped stains can be further improved. Since the dummy lens 256 is not provided on the upper and lower sides of the opening 160a, the repair performance can be improved, and the electrical short can be minimized.

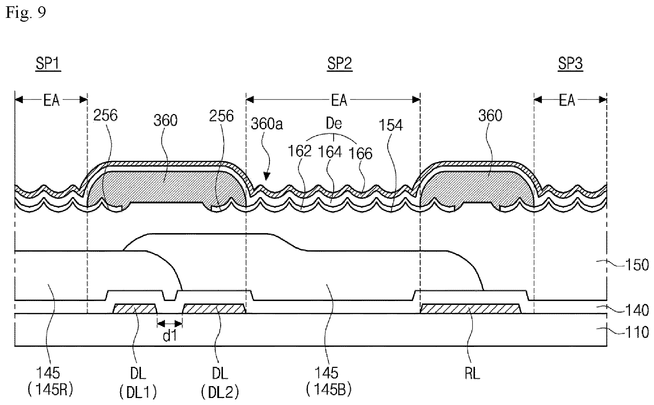

In another embodiment of the present disclosure, the bank of the organic light-emitting diode display device can include a material that blocks light. An organic light-emitting diode display device according to such a fourth embodiment of present disclosure will be described with reference to FIG. 9.

FIG. 9 is a schematic cross-sectional view of an organic light-emitting diode display device according to the fourth embodiment of the present disclosure. The organic light-emitting diode display device according to the fourth embodiment of the present disclosure has substantially the same configuration as that of the first, second, or third embodiment, except for the bank. The same or similar parts as the first, second, or third embodiment will be designated by the same or similar references, and explanation for the same parts will be omitted or shortened.

As shown in FIG. 9, the bank 360 of the organic light-emitting diode display device according to the fourth embodiment of the present disclosure can be a black bank that blocks light.

Specifically, the bank 360 can be formed of a black resin that absorbs light. For example, the black resin can include black pigment and/or carbon black. However, the embodiments of the present disclosure are not limited thereto.

The black bank 360 can decrease a distance d1 between the adjacent data lines DL1 and DL2, thereby improving the aperture ratio.

More particularly, if the bank is formed of a material that transmits light, a configuration such as a slit can be provided in the insulation layer between the adjacent data lines DL1 and DL2 in order to prevent light leakage, and a space for the slit can be needed between the adjacent data lines DL1 and DL2. On the other hand, when the black bank 360 is applied, the slit can be omitted, and the distance d1 between the adjacent data lines DL1 and DL2 can be decreased. Accordingly, the width of the opening 360a of the black bank 360, that is, the width of the emission area EA can be widened, thereby increasing the aperture ratio.

As such, in the fourth embodiments of the present disclosure, by applying the black bank 360 that blocks light, the aperture ratio can be increased, and the luminance can be improved.

In the organic light-emitting diode display device of the embodiments of the present disclosure, the plurality of micro lenses can be provided in the emission area of each sub-pixel, so the light extraction efficiency can be improved.

In addition, the signal lines placed under the bank can be differently designed for each sub-pixel. In this case, by increasing the width of the signal line such that the edges of the opening of at least one sub-pixel can coincide with one side of the signal line corresponding thereto, the uniformity of the bank can be increased, and the vertical stripe-shaped stains can be prevented. The light incident from the adjacent sub-pixels can be blocked by the signal line with the increased width, thereby preventing the light leakage. Moreover, the light trapped inside can be reflected by the signal line with the increased width and output to the outside, thereby further increasing the light extraction efficiency and improving the luminance. Accordingly, the power consumption can be reduced due to the improved efficiency and luminance, thereby implementing the low power consumption.

Additionally, by providing the dummy lens outside the opening of the bank, the vertical stripe-shaped stains can be further improved.

Furthermore, by rotating the micro lenses in at least one sub-pixel, the rainbow pattern and/or the circular ring pattern occurring due to the regular arrangement can be prevented or minimized, thereby improving the image quality of the display device.

Moreover, by applying the black bank that blocks light, the aperture ration can be increased, and the luminance can be further improved.

It will be apparent to those skilled in the art that various modifications and variations can be made in the display device of the present disclosure without departing from the technical idea or scope of the disclosure. Thus, it is intended that the present disclosure cover the modifications and variations of this disclosure provided they come within the scope of the appended claims and their equivalents.

## Claims

1. An organic light-emitting diode display device, comprising:
a substrate (110) including a plurality of sub-pixels (SP1, SP2, SP3, SP4) associated with one pixel, each sub-pixel having an emission area (EA) and a non-emission area (NEA);
at least one horizontal line (SCAN) extending in a first direction and a plurality of vertical lines (DL, RL, PL) extending in a second direction on the substrate (110), wherein the horizontal line (GL) crosses the plurality of vertical lines (DL, RL, PL);
a circuit portion (CP) in the non-emission area (NEA) of each sub-pixel, and including a thin film transistor (Tr) in each sub-pixel (SP1, SP2, SP3, SP4);
an overcoat layer (150) on the thin film transistors (Tr), and including a plurality of micro lenses (154) in the emission area (EA) of each sub-pixel;
a bank (160) on the overcoat layer (150), the bank (160) having an opening (160a) corresponding to the emission area (EA) of each sub-pixel; and
a light-emitting diode (De) disposed in the emission area (EA) of each sub-pixel on the overcoat layer (150), and connected to the corresponding thin film transistor (Tr),
wherein the plurality of vertical lines (DL, RL, PL) includes a first, a second, a third, and a fourth line, and
wherein for a first sub-pixel (SP1) among the plurality of sub-pixels, an edge of the opening (160a) of the bank (160) is spaced apart from the first and second lines (DL1, PL), and for a second sub-pixel (SP2) among the plurality of sub-pixels, an edge of the opening (160a) of the bank (160) coincides with one side of each of the third and fourth lines (DL2, RL).

2. The organic light-emitting diode display device of claim 1, wherein for the first sub-pixel (SP1) among the plurality of sub-pixels, a width of the opening (160a) of the bank (160) is smaller than a distance between the first and second lines (DL1, PL), and for the second sub-pixel (SP2) among the plurality of sub-pixels, a width of the opening (160a) of the bank (160) is equal to a distance between the third and fourth lines (DL2, RL).

3. The organic light-emitting diode display device of claim 1 or 2, wherein one of the first line and the fourth line is a power line (PL), and the other of the first line and the fourth line is a reference line (RL), and/or
wherein the second line and the third line are data lines (DL).

4. The organic light-emitting diode display device according to any one of the preceding claims, wherein a width of the third line is wider than a width of the second line.

5. The organic light-emitting diode display device according to any one of the preceding claims, wherein a color filter (145) is provided between the substrate (110) and the light-emitting diode (De) in at least one of the first and second sub-pixels (SP1, SP2).

6. The organic light-emitting diode display device according to any one of the preceding claims, wherein the first sub-pixel (SP1) and/or the second sub-pixel (SP2) includes at least one dummy lens (256) formed in the overcoat layer (150) in the non-emission area (NEA) of said sub-pixel (SP1, SP2) and/or spaced apart from the opening (160a) of the bank (160) defining the emission area (EA) of said sub-pixel (SP1, SP2).

7. The organic light-emitting diode display device of claim 6, wherein the dummy lens (256) has a same size and/or shape as the micro lenses (154) formed in the overcoat layer (150) in the emission area (EA) of said sub-pixel (SP1, SP2).

8. The organic light-emitting diode display device according to any one of the preceding claims, wherein the light-emitting diode (De) includes a first electrode (162) on the overcoat layer (150), a light-emitting layer (164) on the first electrode (162), and a second electrode (166) on the light-emitting layer (164).

9. The organic light-emitting diode display device of claim 8 in combination with claim 6 or 7, wherein the dummy lens (256) is overlapped by an edge of the first electrode (162) extending in the second direction and/or is spaced apart from opposite edges of the first electrode (162) extending in the first direction.

10. The organic light-emitting diode display device according to any one of the preceding claims, wherein the micro lenses (154) in at least one of the sub-pixels (SP1, SP2, SP3, SP4) are rotated at a rotation angle, so that a line connecting centers of the micro lenses (154) adjacent to each other has a specific angle with respect to the first direction.

11. The organic light-emitting diode display device of claim 10, wherein the rotation angle of the micro lenses is greater than 0 degrees and/or is equal to or less than 60 degrees.

12. The organic light-emitting diode display device according to any one of the preceding claims, wherein the bank (160) is a black bank configured to block light.

13. The organic light-emitting diode display device according to any one of the preceding claims, wherein the micro lenses (54) may have a pentagonal shape or honeycombed shape.
